# EUROPÄISCHE PATENTSCHRIFT

(11) **EP 2 989 227 B1**
(45) Veröffentlichungstag und Bekanntmachung des Hinweises auf die Patenterteilung: **27.06.2018**
(21) Anmeldenummer: 14718568.0
(22) Anmeldetag: 16.04.2014
(51) Int. Cl.: C23C 16/455, C23C 16/34

(54) **WERKZEUG MIT CVD-BESCHICHTUNG**
TOOL HAVING CVD COATING
OUTIL REVÊTU PAR DÉPÔT CHIMIQUE EN PHASE VAPEUR

(30) Priorität: 26.04.2013 DE 102013104254
(43) Veröffentlichungstag der Anmeldung: 02.03.2016
(73) Patentinhaber: Walter AG, 72072 Tübingen (DE)
(72) Erfinder: STIENS, Dirk, 72076 Tübingen (DE); RUPPI, Sakari, 8500-308 Portimao (PT); MANNS, Thorsten, 72074 Tübingen (DE)
(74) Vertreter: WSL Patentanwälte Partnerschaft mbB
(86) Internationale Anmeldenummer: PCT/EP2014/057720
(87) Internationale Veröffentlichungsnummer: WO 2014/173755

(56) Entgegenhaltungen:
- JP-A- 2001 341 008
- JP-A- 2007 168 032
- ENDLER I ET AL: "Aluminum-rich TiAlCN coatings by Low Pressure CVD", SURFACE AND COATINGS TECHNOLOGY, ELSEVIER, AMSTERDAM, NL, Bd. 205, Nr. 5, 25. November 2010 (2010-11-25), Seiten 1307-1312, XP027507482, ISSN: 0257-8972, DOI: 10.1016/J.SURFCOAT.2010.09.002 [gefunden am 2010-09-07]

## Beschreibung

### Gegenstand der Erfindung

Die Erfindung betrifft ein Werkzeug mit einem Grundkörper aus Hartmetall, Cermet, Keramik, Stahl oder Schnellarbeitsstahl und einer darauf im CVD-Verfahren aufgebrachten ein- oder mehrlagigen Verschleißschutzbeschichtung, wobei die Verschleißschutzbeschichtung wenigstens eine Ti₁₋ₓAlₓC_{y}N_{z}-Lage aufweist mit Stöchiometriekoeffizienten 0,70 ≤ x < 1, 0 ≤ y < 0,25 und 0,75 ≤ z < 1,15 und mit einer kristallographischen Vorzugsorientierung. Weiterhin betrifft die Erfindung ein Verfahren zur Herstellung eines solchen Werkzeugs.

### Hintergrund der Erfindung

Schneideinsätze für die Werkstoffbearbeitung, insbesondere für die zerspanende Metallbearbeitung, bestehen aus einem Substratkörper aus Hartmetall, Cermet, Keramik, Stahl oder Schnellarbeitsstahl, der in den meisten Fällen zur Verbesserung der Schneid- und/oder Verschleißeigenschaften mit einer ein- oder mehrlagigen Hartstoffbeschichtung versehen ist. Die Hartstoffbeschichtung besteht aus übereinander angeordneten Lagen monometallischer oder gemischtmetallischer Hartstoffphasen. Beispiele für monometallische Hartstoffphasen sind TiN, TiC, TiCN und Al₂O₃. Beispiele für gemischtmetallische Phasen, bei denen in einem Kristall ein Metall teilweise durch ein anderes ersetzt ist, sind TiAIN und TiAICN. Beschichtungen der vorgenannten Art werden durch CVD-Verfahren (chemische Dampfphasenabscheidung), PCVD-Verfahren (Plasma-unterstützte CVD-Verfahren) oder durch PVD-Verfahren (physikalische Dampfphasenabscheidung) aufgebracht.

Es hat sich gezeigt, dass bestimmte Vorzugsorientierungen des Kristallwachstums bei der Abscheidung im PVD- oder CVD-Verfahren besondere Vorteile haben können, wobei für unterschiedliche Anwendungen des Schneideinsatzes auch unterschiedliche Vorzugsorientierungen bestimmter Lagen einer Beschichtung besonders vorteilhaft sein können. Die Vorzugsorientierung des Wachstums wird in der Regel in Bezug auf die über die Miller-Indizes definierten Ebenen des Kristallgitters angegeben und als kristallographische Textur (z. B. Fasertextur) bezeichnet.

Die DE 10 2005 032 860 offenbart eine Hartstoffbeschichtung mit einer Lage aus kubisch flächenzentriertem Ti₁₋ₓAlₓN mit einem Al-Gehalt von 0,75 < x < 0,93 und ein Verfahren zu deren Herstellung.

Die DE 10 2007 000 512 offenbart eine Hartstoffbeschichtung mit einer Lage aus TiAIN, die auf einer unmittelbar auf dem Substrat abgeschiedenen ersten Lage aus TiN, TiCN oder TiC und einer zwischen den beiden Lagen vorgesehenen Anbindungslage mit einem Phasengradienten abgeschieden ist. Die Lage aus TiAIN weist eine Vorzugsorientierung des Kristallwachstums bezüglich der (200)-Ebene des Kristallgitters auf.

Die Offenlegungsschriften WO 2009/112115, WO 2009/112116 und WO 2009/112117A1 offenbaren mittels CVD-Verfahren abgeschiedene TiAIN- und TiAlCN-Lagen mit hohem Al-Anteil und kubisch flächenzentriertem Gitter, jedoch sind keine kristallographischen Vorzugsorientierungen des Kristallwachstums beschrieben. I. Endler et al beschreiben in Surface & Coatings Technologhy 205 (210) 1307-1312 CVD-Verfahren für aluminiumreiche TiAlCN-Beschichtungen, die eine Vorzugsorientierung der {111}- und {200}-Ebenen aufweisen.

Aus der JP2001341008A sind CVD-TiAlN Beschichtungen mit Vorzugsorientierung der {111}-Ebene bekannt.

Aus der JP200716803A ist bekannt CVD-TiAlN Beschichtungen in einem zylindrischen CVD-Reaktor auszuführen, wobei die zu beschichtenden Körper radial zur Längsachse des Reaktors angeströmt werden.

Mittels PVD-Verfahren hergestellte TiAIN-Beschichtungen mit verschiedenen kristallographischen Vorzugsorientierungen des Kristallwachstums sind bekannt, jedoch sind PVD-Beschichtungen mit kubisch flächenzentriertem Gitter der TiAIN-Beschichtungen im Gegensatz zu CVD-Beschichtungen auf Al-Gehalte von weniger als 67 % beschränkt. TiAIN-Beschichtungen mit einer kristallographischen Vorzugsorientierung der {200}-Ebene bezüglich der Wachstumsrichtung der Kristallite werden als vorteilhaft für die Metallbearbeitung beschrieben (z. B. US 2009/0274899, US 2009/0074521 und WO 2009/127344).

### Aufgabe

Die Aufgabe der vorliegenden Erfindungen bestand in der Bereitstellung von Schneideinsätzen für die spanende Metallbearbeitung, insbesondere die Dreh- und Fräsbearbeitung von Stahl-oder Gusswerkstoffen, die eine gegenüber dem Stand der Technik verbesserte Verschleißbeständigkeit aufweisen.

### Beschreibung der Erfindung

Gelöst wird diese Aufgabe durch ein Verfahren zur Herstellung eines Werkzeugs mit einem Grundkörper aus Hartmetall, Cermet, Keramik, Stahl oder Schnellarbeitsstahl und einer darauf im CVD-Verfahren aufgebrachten ein- oder mehrlagigen Verschleißschutzbeschichtung, wobei die Verschleißschutzbeschichtung wenigstens eine Ti₁₋ₓAlₓC_{y}N_{z}-Lage aufweist mit Stöchiometriekoeffizienten 0,70 ≤ x < 1, 0 ≤ y < 0,25 und 0,75 ≤ z < 1,15 und mit einer Dicke im Bereich von 1 µm bis 25 µm, wobei zur Herstellung der Ti₁₋ₓAlₓC_{y}N_{z}-Lage
a) die zu beschichtenden Körper in einem im Wesentlichen zylindrischen CVD-Reaktor platziert werden, der für ein Anströmen der zu beschichtenden Körper mit den Prozessgasen in einer Richtung im Wesentlichen radial zur Längsachse des Reaktors ausgelegt ist,
b) zwei Vorläufergasgemische (VG1) und (VG2) bereitgestellt werden, wobei
   das erste Vorläufergasgemisch (VG1)
   0,005% bis 0,2 Vol.-% TiCl₄,
   0,025% bis 0,5 Vol.-% AlCl₃ und
   als Trägergas Wasserstoff (H₂) oder ein Gemisch aus Wasserstoff und Stickstoff (H₂/N₂) enthält und
   das zweite Vorläufergasgemisch (VG2)
   0,1 bis 3,0 Vol.-% wenigstens eines N-Donors, ausgewählt unter Ammoniak (NH₃) und Hydrazin (N₂H₄), und
   als Trägergas Wasserstoff (H₂) oder ein Gemisch aus Wasserstoff und Stickstoff (H₂/N₂) enthält,
   und das erste Vorläufergasgemisch (VG1) und/oder das zweite Vorläufergasgemisch (VG2) gegebenenfalls einem C-Donor, ausgewählt unter Acetonitril (CH₃CN), Ethan (C₂H₆), Ethen (C₂H₄) und Ethin (C₂H₂) und Gemischen davon, enthält, wobei der Gesamt-Vol.-%-Anteil von N-Donor und C-Donor in den Vorläufergasgemischen (VG1, VG2) im Bereich von 0,1 bis 3,0 Vol.-% liegt,
c) die zwei Vorläufergasgemische (VG1, VG2) vor dem Eintritt in die Reaktionszone getrennt gehalten werden und bei einer Prozesstemperatur im CVD-Reaktor im Bereich von 600°C bis 850 °C und einem Prozessdruck im CVD-Reaktor im Bereich von 0,2 bis 18 kPa im Wesentlichen radial zur Längsachse des Reaktors eingeleitet werden, wobei das Verhältnis der Volumengasströme (*v̇*) der Vorläufergasgemische (VG1, VG2) *v̇* (VG1)/ *v̇* (VG2) kleiner als 1,5 beträgt.

Im Sinne der vorliegenden Erfindung beziehen sich Vol.-%-Anteile in den Vorläufergasgemischen auf das Gesamtvolumen des in die Reaktionszone eingeleiteten Gasgemisches aus den ersten und zweiten Vorläufergasgemischen.

Es wurde überraschend gefunden, dass durch die erfindungsgemäße Prozessführung Ti₁₋ₓAlₓC_{y}N_{z}- und Ti₁₋ₓAlₓN_{z}-Lagen mit Stöchiometriekoeffizienten 0,70 ≤ x < 1, 0 ≤ y < 0,25 und 0,75 ≤ z < 1,15 und mit kubisch flächenzentriertem Gitter hergestellt werden können, die eine ausgeprägte Vorzugsorientierung des Kristallwachstums bezüglich der {111}-Ebene des Kristallgitters aufweisen. Die erfindungsgemäßen Beschichtungen weisen im Vergleich zu bekannten Beschichtungen mit TiAICN- und TiAIN-Lagen, insbesondere solchen mit Vorzugsorientierung des Kristallwachstums bezüglich der {200}-Ebene des Kristallgitters, überragende Eigenschaften in der Metallbearbeitung auf. Es wurde weiterhin überraschenderweise gefunden, dass man bei einem Schneideinsatz mit einer Beschichtung der hierin beschriebenen Art bei der spanenden Metallbearbeitung, insbesondere bei der Dreh- und Fräsbearbeitung von Stahl- oder Gusswerkstoffen, eine gegenüber bekannten Schneideinsätzen verbesserte Verschleißbeständigkeit und einem breiteren Anwendungsbereich erzielen kann.

Bei dem erfindungsgemäßen CVD-Verfahren werden zwei Vorläufergasgemische (VG1) und (VG2) bereitgestellt, wobei das erste Vorläufergasgemisch (VG1) die Metalle Ti und Al in der Form ihrer Chloride und Trägergas enthält und das zweite Vorläufergasgemisch (VG2) wenigstens einen N-Donor enthält. Für die Herstellung einer reinen TiAIN-Lage wird in der Regel nur N-Donor Ammoniak (NH₃) oder Hydrazin (N₂H₄) eingesetzt. Für die Herstellung TiAlCN-Lage werden N-Donor und C-Donor eingesetzt, beispielsweise Ammoniak (NH₃) im Gemisch mit Ethen (C₂H₄). Acetonitril (CH₃CN) wirkt im erfindungsgemäßen Verfahren überwiegend als C-Donor und wird demzufolge im Gemisch mit einem N-Donor eingesetzt. Je nach gewünschter Stöchiometrie können Gemische mit weiteren N-Donoren und C-Donoren eingesetzt werden. Für das erfindungsgemäße Verfahren ist erforderlich, dass der N-Donor getrennt von den Chloriden der Metalle Ti und Al zugeführt wird, dagegen kann der C-Donor sowohl über das erste Vorläufergasgemisch (VG1) als auch über das zweite Vorläufergasgemisch (VG2) zugeführt werden. In einer weiteren bevorzugten Ausführungsform der Erfindung ist der N-Donor Ammoniak (NH₃).

Das erfindungsgemäß angewendete CVD-Verfahren ist ein MT-CVD-Verfahren bei einer Prozesstemperatur im CVD-Reaktor im Bereich von 600°C bis 850 °C und einem Prozessdruck im Bereich von 0,2 bis 18 kPa. Der CVD-Reaktor ist ein im Wesentlichen zylindrischer Reaktor, der für ein Anströmen der zu beschichtenden Körper mit den Prozessgasen in einer Richtung im Wesentlichen radial zur Längsachse des Reaktors ausgelegt ist, d. h. von der Mittelachse des zylindrischen Reaktors in Richtung der vom Zylindermantel gebildeten Außenwände des Reaktors. Solche zylindrischen Reaktoren sind bekannt und kommerziell erhältlich, beispielsweise die CVD-Beschichtungssysteme des Typs Bernex® BPXpro der Firma lonbond AG Olten, Schweiz.

Eine wesentliche Verfahrensmaßnahme des erfindungsgemäßen Verfahrens besteht darin, dass die zwei Vorläufergasgemische (VG1) und (VG2) vor dem Eintritt in die Reaktionszone getrennt gehalten werden. Wird dies nicht eingehalten, können die Vorläufergasströme bereits zu früh reagieren, beispielsweise in den Zuführungsleitungen, und die gewünschte Beschichtung wird nicht erzielt.

Eine weitere wesentliche Verfahrensmaßnahme des erfindungsgemäßen Verfahrens besteht darin, dass das Verhältnis der Volumengasströme (*v̇*) der Vorläufergasgemische (VG1, VG2) *v̇* (VG1) / *v̇* (VG2) kleiner als 1,5 beträgt. Wählt man das Verhältnis der Volumengasströme (*v̇*) der Vorläufergasgemische (VG1, VG2) *v̇* (VG1) / *v̇* (VG2) größer als 1,5, erhält man nicht die gewünschten Eigenschaften der Ti₁₋ₓAlₓC_{y}N_{z}-Lage, insbesondere nicht die Vorzugsorientierung des Kristallwachstums bezüglich der {111}-Ebene des Kristallgitters, die hierin als das Verhältnis der Intensitäten der Röntgenbeugungspeaks I{111} / I{200} definiert ist und erfindungsgemäß >1+ h (In h)² sein soll, wobei h die Dicke der Ti₁₋ₓAlₓC_{y}N_{z}-Lage in "µm" ist.

In einer bevorzugten Ausführungsform der Erfindung liegt die Prozesstemperatur im CVD-Reaktor im Bereich von 650°C bis 800 °C, vorzugsweise im Bereich von 675°C bis 750 °C.

Ist die Prozesstemperatur im CVD-Reaktor zu hoch, werden hohe Gehalte an hexagonalem AIN in der Schicht erhalten, wodurch u.a. die Schichthärte sinkt.

Ist die Prozesstemperatur im CVD-Reaktor hingegen zu niedrig, kann die Abscheiderate in einen unwirtschaftlichen Bereich sinken. Zudem werden bei niedrigen Temperaturen Schichten mit Chlor-Gehalten >1 At.-% und geringerer Härte erhalten.

In einer weiteren bevorzugten Ausführungsform der Erfindung liegt der Prozessdruck im CVD-Reaktor im Bereich von 0,2 bis 7 kPa, vorzugsweise im Bereich von 0,4 bis 1,8 kPa.

Ist der Prozessdruck im CVD-Reaktor zu hoch, führt dies zu einer ungleichmäßigen Schichtdicken-Verteilung an den Werkzeugen mit erhöhter Schichtdicke an den Kanten, dem sogenannten Dogbone-Effekt. Zudem werden häufig hohe Anteile an hexagonalem AIN erhalten.

Ein Prozessdruck im CVD-Reaktor kleiner 0,2 kPa ist hingegen technisch schwierig zu realisieren. Zudem ist bei zu niedrigem Prozessdruck die gleichmäßige Beschichtung der Werkzeuge nicht mehr gewährleistet.

In einer weiteren bevorzugten Ausführungsform der Erfindung ist das Verhältnis der Volumengasströme (*v̇*) der Vorläufergasgemische (VG1, VG2) *v̇* (VG1)/ *v̇* (VG2) kleiner als 1,25, vorzugsweise kleiner als 1,15.

Ist das Verhältnis der der Volumengasströme (*v̇*) der Vorläufergasgemische (VG1, VG2) zu hoch, wird in der Regel eine andere als die erfindungsgemäße {111}-Vorzugsorientierung erhalten.

In einer weiteren bevorzugten Ausführungsform der Erfindung werden die Konzentration von TiCl₄ in dem Vorläufergasgemisch (VG1) und die Konzentration von N-Donor in dem Vorläufergasgemisch (VG2) so eingestellt, dass das molare Verhältnis von Ti zu N in den in Stufe c) in den Reaktor einleiteten Volumengasströmen *v̇* (VG1) und *v̇* (VG2) ≤ 0,25 beträgt.

Es wurde überraschend festgestellt, dass man bei einem höheren molaren Verhältnis von Ti zu N der in den Reaktor einleiteten Volumengasströmen *v̇* (VG1) und *v̇* (VG2) sehr Ti-reiche Lagen erhält, insbesondere bei Verwendung von Ammoniak (NH₃) als N-Donor. Es wird vermutet, dass bei einem zu hohen Verhältnis von Ti zu N in den Volumengasströmen die Reaktion des AlCl₃ aufgrund von Komplexbildung zwischen TiCl₄ und dem N-Donor zurückgedrängt wird.

In einer weiteren bevorzugten Ausführungsform der Erfindung enthält das zweite Vorläufergasgemisch (VG2) ≤ 1,0 Vol.-%, vorzugsweise ≤ 0,6 Vol.-% des N-Donors.

Ist die Konzentration des N-Donors, gegebenenfalls im Gemisch mit C-Donor, in dem zweiten Vorläufergasgemisch (VG2) zu hoch, so werden die gewünschte Zusammensetzung und kristallographische Vorzugsorientierung nicht erhalten.

In einer weiteren bevorzugten Ausführungsform der Erfindung wird die Verschleißschutzbeschichtung einer Strahlbehandlung mit einem partikulären Strahlmittel, vorzugsweise Korund, unter Bedingungen unterzogen, dass die Ti₁₋ₓAlₓC_{y}N_{z}-Lage nach der Strahlbehandlung Eigenspannungen im Bereich von +300 bis -5000 MPa, vorzugsweise im Bereich von -1 bis -3500 MPa aufweist.

Ist die Druckeigenspannung der Ti₁₋ₓAlₓC_{y}N_{z}-Lage zu hoch, so kann es zum Abplatzen der Beschichtung an den Kanten des Werkzeugs kommen.

Liegen hingegen Zugeigenspannungen in der Ti₁₋ₓAlₓC_{y}N_{z}-Lage vor, so wird nicht die optimale Beständigkeit des Werkzeugs gegen thermomechanische Wechselbeanspruchung bzw. gegen die Ausbildung von Kammrissen erzielt.

Zum Einbringen der bevorzugten Eigenspannungen in die Ti₁₋ₓAlₓC_{y}N_{z}-Lage lassen sich mit Vorteil Trocken- oder Nassstrahlbehandlung einsetzen. Die Strahlbehandlung wird zweckmäßigerweise bei einem Strahlmitteldruck von 1 bar bis 10 bar durchgeführt.

Die für das Einbringen der erfindungsgemäßen Eigenspannungen erforderliche Dauer der Strahlbehandlung und der erforderliche Strahldruck sind Parameter, die der Fachmann innerhalb der hierin definierten Grenzen durch einfache Experimente ermitteln kann. Eine pauschale Angabe ist hier nicht möglich, da die sich einstellenden Eigenspannungen nicht nur von der Dauer der Strahlbehandlung und dem Strahldruck abhängen, sondern auch von dem Aufbau und der Dicke der Gesamtbeschichtung. Allerdings hat der Strahldruck dabei im Vergleich zur Strahldauer den wesentlich größeren Einfluss auf die Veränderung der Eigenspannungen in der Beschichtung und dem Substratkörper. Geeignete Strahlbehandlungsdauern liegen üblicherweise im Bereich von 10 bis 600 Sekunden.

Der Strahlwinkel, d. h. der Winkel zwischen dem Behandlungsstrahl und der Oberfläche des Werkzeugs, hat ebenfalls einen wesentlichen Einfluss auf den Eintrag von Eigenspannungen. Bei einem Strahlwinkel von 90° erfolgt der maximale Eintrag von Druckeigenspannungen. Geringere Strahlwinkel, d. h. schräges Einstrahlen des Strahlmittels, führen zu einer stärkeren Abrasion der Oberfläche und geringerem Druckeigenspannungseintrag.

Die Erfindung umfasst auch ein Werkzeug mit einem Grundkörper aus Hartmetall, Cermet, Keramik, Stahl oder Schnellarbeitsstahl und einer darauf im CVD-Verfahren aufgebrachten ein- oder mehrlagigen Verschleißschutzbeschichtung, wobei die Verschleißschutzbeschichtung wenigstens eine Ti₁₋ₓAlₓC_{y}N_{z}-Lage aufweist mit Stöchiometriekoeffizienten 0,70 ≤ x < 1, 0 ≤ y < 0,25 und 0,75 ≤ z < 1,15, dadurch gekennzeichnet, dass
die Ti₁₋ₓAlₓC_{y}N_{z}-Lage eine Dicke im Bereich von 1 µm bis 25 µm hat und eine kristallographische Vorzugsorientierung aufweist, die durch ein Verhältnis der Intensitäten der Röntgenbeugungspeaks der kristallografischen {111}-Ebene und der {200}-Ebene charakterisiert ist, bei dem I{111} / I{200} > 1+h (In h)², wobei h die Dicke der Ti₁₋ₓAlₓC_{y}N_{z}-Lage in "µm" ist.

In einer bevorzugten Ausführungsform der Erfindung beträgt die Halbwertsbreite (FWHM) des Röntgenbeugungspeaks der {111}-Ebene der Ti₁₋ₓAlₓC_{y}N_{z}-Lage < 1°, vorzugsweise < 0,6°, besonders bevorzugt < 0,45°.

Ein zu hohe Halbwertsbreite (FWHM) des Röntgenbeugungspeaks der {111}-Ebene der Ti₁₋ₓAlₓC_{y}N_{z}-Lage deutet auf geringere Korngrößen der kubisch flächenzentrierten (fcc) Phase oder gar auf Anteile amorpher Phasen hin. Dies hat sich in den bisherigen Tests als nachteilig für die Verschleißbeständigkeit erwiesen.

In einer weiteren bevorzugten Ausführungsform der Erfindung weist die Ti₁₋ₓAlₓC_{y}N_{z}-Lage wenigstens 90 Vol.-% Ti₁₋ₓAlₓC_{y}N_{z}-Phase mit kubisch flächenzentriertem (fcc) Gitter, vorzugsweise wenigstens 95 Vol.-% Ti₁₋ₓAlₓC_{y}N_{z}-Phase mit kubisch flächenzentriertem (fcc) Gitter, besonders bevorzugt wenigstens 98 Vol.-% Ti₁₋ₓAlₓC_{y}N_{z}-Phase mit kubisch flächenzentriertem (fcc) Gitter auf.

Ist der Anteil an Ti₁₋ₓAlₓC_{y}N_{z}-Phase mit kubisch flächenzentriertem (fcc) Gitter zu gering, wird eine geringere Verschleißbeständigkeit beobachtet.

In einer weiteren bevorzugten Ausführungsform der Erfindung weist die Ti₁₋ₓAlₓC_{y}N_{z}-Lage Stöchiometriekoeffizienten 0,70 ≤ x < 1, y = 0 und 0,95 ≤ z < 1,15 auf.

In einer weiteren bevorzugten Ausführungsform der Erfindung weist die Ti₁₋ₓAlₓC_{y}N_{z}-Lage eine Dicke im Bereich von 3 µm bis 20 µm, vorzugsweise im Bereich von 4 bis 15 µm auf.

Ist die Dicke der die Ti₁₋ₓAlₓC_{y}N_{z}-Lage zu gering, ist die Verschleißbeständigkeit des Werkzeugs nicht ausreichend.

Ist die Dicke der die Ti₁₋ₓAlₓC_{y}N_{z}-Lage hingegen zu hoch, kann es aufgrund der thermischen Eigenspannungen nach der Beschichtung zum Abplatzen der Schicht kommen.

In einer weiteren bevorzugten Ausführungsform der Erfindung beträgt das Verhältnis der Intensitäten der Röntgenbeugungspeaks der kristallografischen {111}-Ebene und der (200)-Ebene der Ti₁₋ₓAlₓC_{y}N_{z}-Lage > 1+(h+3)x(In h)².

In einer weiteren bevorzugten Ausführungsform der Erfindung weist die Ti₁₋ₓAlₓC_{y}N_{z}-Lage eine Vickers-Härte (HV) > 2300 HV, vorzugsweise > 2750 HV, besonders bevorzugt > 3000 HV auf.

In einer weiteren bevorzugten Ausführungsform der Erfindung ist zwischen dem Grundkörper und der Ti₁₋ₓAlₓC_{y}N_{z}-Lage wenigstens eine weitere Hartstofflage angeordnet, ausgewählt unter einer TiN-Lage, einer mittels Hochtemperatur-CVD (CVD) oder Mitteltemperatur-CVD (MT-CVD) abgeschiedenen TiCN-Lage, einer Al₂O₃-Lage und Kombinationen davon. Besonders bevorzugt ist es, die weiteren Lagen im gleichen Temperaturbereich, d. h. durch Mitteltemperatur-CVD (MT-CVD), aufzubringen wie die Ti₁₋ₓAlₓC_{y}N_{z}-Lage, um unwirtschaftliche Abkühlzeiten zu vermeiden.

In einer weiteren bevorzugten Ausführungsform der Erfindung ist über der Ti₁₋ₓAlₓC_{y}N_{z}-Lage wenigstens eine weitere Hartstofflage angeordnet ist, vorzugsweise wenigstens eine Al₂O₃-Lage der Modifikation γ-Al₂O₃, κ-Al₂O₃ oder α-Al₂O₃, wobei die Al₂O₃-Lage mittels Hochtemperatur-CVD (CVD) oder Mitteltemperatur-CVD (MT-CVD) abgeschieden ist. Besonders bevorzugt ist es, die Aluminiumoxid-Lage aus den oben genannten Gründen im gleichen Temperaturbereich, d. h. durch Mitteltemperatur-CVD (MT-CVD), aufzubringen wie die Ti₁₋ₓAlₓC_{y}N_{z}-Lage, um mögliche Phasenumwandlungen der Ti₁₋ₓAlₓC_{y}N_{z}-Lage zu vermeiden. Verfahren zur Herstellung von γ-Al₂O₃, κ-Al₂O₃ oder α-Al₂O₃-Schichten im Bereich von 600 bis 850°C sind dem Fachmann bekannt, beispielsweise aus EP 1 122 334 und EP 1 464 727.

In einer weiteren bevorzugten Ausführungsform ist die kristallographische Vorzugsorientierung der {111}-Ebene der fcc-Ti₁₋ₓAlₓC_{y}N_{z}-Lage derart ausgeprägt, dass sich das röntgenographisch oder mittels EBSD gemessene absolute Maximum der {111}-Intensität der fcc-Ti₁₋ₓAlₓC_{y}N_{z}-Lage innerhalb eines Winkelbereichs von α = ±10°, bevorzugt innerhalb α = ±5°, besonders bevorzugt innerhalb α = ±1° befindet, ausgehend von der Normalenrichtung der Probenoberfläche. Maßgeblich hierbei ist der Schnitt durch die {111}-Polfigur des fcc-Ti₁₋ₓAlₓC_{y}N_{z} nach Integration der Intensitäten über den Azimut-Winkel β (Rotationswinkel um die Probenoberflächennormale).

### Beschreibung der Figuren

- Figur 1:: Schneidkante einer Wendeschneidplatte mit Beschichtung Nr. 9 nach dem Stand der Technik nach einem Drehversuch;
- Figur 2:: Schneidkante einer Wendeschneidplatte mit Beschichtung Nr. 8 nach dem Stand der Technik nach einem Drehversuch;
- Figur 3:: Schneidkante einer Wendeschneidplatte mit erfindungsgemäßer Ti₁₋ₓAlₓC_{y}N_{z}-Beschichtung Nr. 1 nach einem Drehversuch;

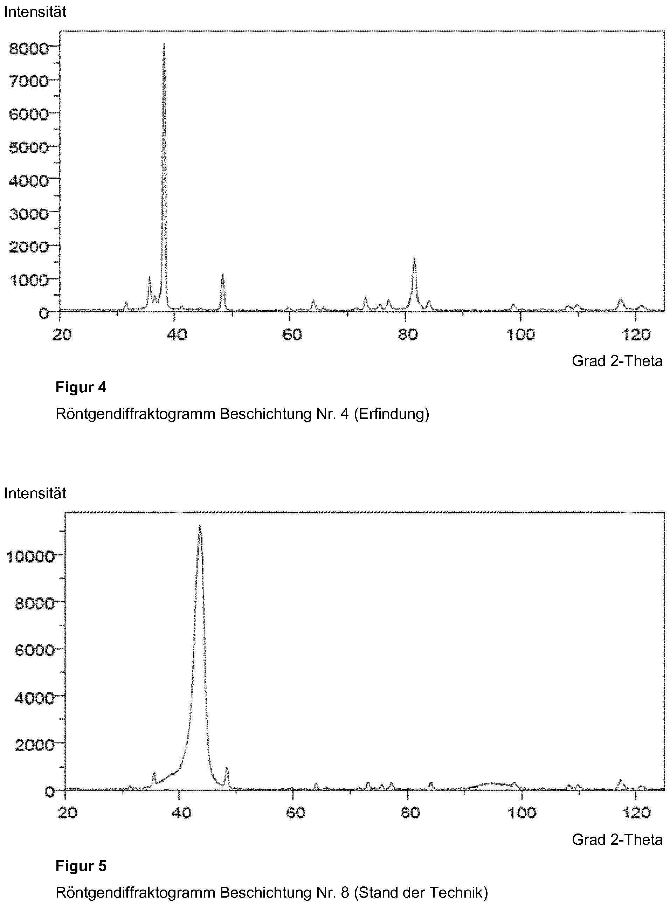

- Figur 4:: Röntgendiffraktogramm der Beschichtung Nr. 4 (Erfindung);
- Figur 5:: Röntgendiffraktogramm der Beschichtung Nr. 8 (Stand der Technik);

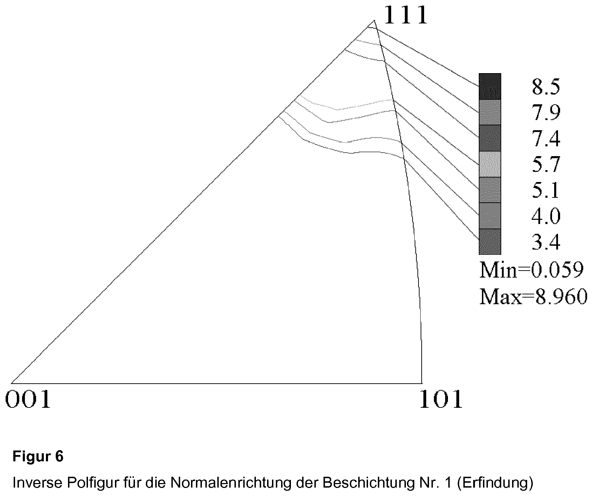

- Figur 6:: Inverse Polfigur für die Normalenrichtung der Beschichtung Nr. 1 (Erfindung);

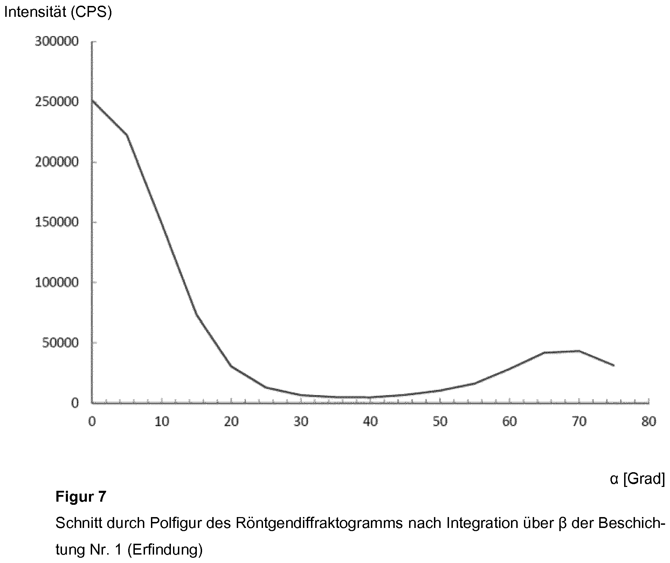

- Figur 7:: Schnitt durch Polfigur des Röntgendiffraktogramms nach Integration über β der Beschichtung Nr. 1 (Erfindung);

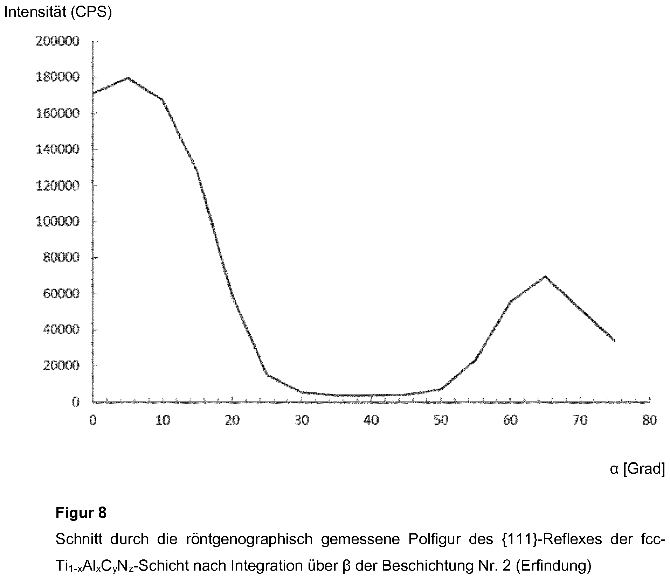

- Figur 8:: Schnitt durch die Polfigur des Röntgendiffraktogramms nach Integration über β der Beschichtung Nr. 2 (Erfindung).

### Beispiele

### Herstellung von beschichteten Hartmetall-Wendeschneidplatten

Als Substratkörper wurden in diesen Beispielen Hartmetall-Wendeschneidplatten der Geometrie CNMA120412 mit einer Zusammensetzung von 86,5 Gew.-% WC, 5,5 Gew.-% Co, 2 Gew.-% TiC, 6 Gew.-% (NbC+TaC) und mit einer mischcarbidfreien Randzone verwendet.

Zur Beschichtung der Hartmetall-Wendeschneidplatten wurde eine CVD-Beschichtungsanlage des Typs Bernex BPX325S mit einer Reaktorhöhe von 1250 mm und einem Reaktordurchmesser von 325 mm eingesetzt. Der Gasfluss erfolgte radial zur Längsachse des Reaktors.

Zur Anbindung der erfindungsgemäßen Ti₁₋ₓAlₓC_{y}N_{z}-Lagen sowie der Vergleichslagen wurde unmittelbar auf dem Hartmetall-Substrat zunächst eine etwa 0,3 µm dicke TiN-Lage oder TiCN-Lage mittels CVD unter den in Tabelle 1 angegebenen Abscheidebedingungen aufgebracht:

**Tabelle 1: Reaktionsbedingungen bei der Herstellung von Anbindungslagen**

| **Anbindungslage** | **Temp. [°C]** | **Druck [kPA]** | **Reaktivgasgemisch [Vol.-%]** | | | |
|---|---|---|---|---|---|---|
| | | | TiCl₄ | N₂ | H₂ | CH₃CN |
| TiN | 850 | 15 | 0,8 | 44,1 | 55,1 | --- |
| TiCN | 830 | 6 | 1,0 | 37,0 | 61,7 | 0,3 |

Zur Herstellung der erfindungsgemäßen Ti₁₋ₓAlₓC_{y}N_{z}-Lagen wurden ein erstes Vorläufergasgemisch (VG1) mit den Ausgangsverbindungen TiCl₄ und AlCl₃ und ein zweites Vorläufergasgemisch (VG2) mit der Ausgangsverbindung NH₃ als reaktive Stickstoffverbindung voneinander getrennt in den Reaktor eingeleitet, so dass eine Vermischung der beiden Gasströme erst bei Eintritt in die Reaktionszone erfolgte.

Die Volumengasströme der Vorläufergasgemische (VG1) und (VG2) wurden so eingestellt, dass bei Herstellung erfindungsgemäßer Beschichtungen das Verhältnis der Volumengasströme *v̇* (VG1) / *v̇* (VG2) kleiner als 1,5 war. Die Parameter bei der Herstellung erfindungsgemäßer Ti₁₋ₓAlₓC_{y}N_{z}-Beschichtungen sowie von Vergleichsbeschichtungen sind in Tabelle 3 wiedergegeben.

### Herstellung von Vergleichsbeschichtungen

Als weitere Vergleichsbeispiele nach dem Stand der Technik wurden Hartmetall-Wendeschneidplatten mit
a) einem 12 µm dicken Lagensystem der Abfolge TiN / MT-Ti(C,N) / TiN (Beschichtung Nr. 9) und
b) einem 5 µm dicken Lagensystem der Abfolge TiN / MT-Ti(C,N) (Beschichtung Nr. 10) beschichtet. Hierfür wurden die Abscheidebedingungen gemäß nachfolgender Tabelle 2 verwendet:

**Tabelle 2: Reaktionsbedingungen bei der Herstellung der Beschichtung Nr. 9 und 10 (Vgl.)**

| **Lagen** | **Temp. [°C]** | **Druck [kPA]** | **Zeit [min]** | **Reaktivgasgemisch [Vol.-%]** | | | | **Dicke [µm]** |
|---|---|---|---|---|---|---|---|---|
| | | | | TiCl₄ | N₂ | H₂ | CH₃CN | |
| **Beschichtung Nr.9** | | | | | | | | |
| TiN | 910 | 16 | 60 | 1,1 | 39,6 | 59,4 | --- | 0,5 |
| MT-TiCN | 890 | 12 | 220 | 1,8 | 10,7 | 85,9 | 0,9 | 11 |
| TiN | 920 | 80 | 50 | 0,8 | 22,4 | 76,8 | --- | 0,5 |

| **Beschichtung Nr.10** | | | | | | | | |
|---|---|---|---|---|---|---|---|---|
| TiN | 910 | 16 | 30 | 1,1 | 39,6 | 59,4 | --- | 0,2 |
| MT-TiCN | 870 | 9 | 105 | 1,8 | 10,7 | 85,9 | 0,9 | 4,8 |

Zur Untersuchung von Zusammensetzung, Textur, Eigenspannungen und Härte der Beschichtungen wurden folgende Verfahren verwendet.

Zur Bestimmung der kristallographischen Vorzugsorientierung können sowohl Verfahren der Röntgenbeugung (XRD) als auch Elektronenbeugung, insbesondere EBSD, angewendet werden. Zur sicheren Bestimmung einer Vorzugsorientierung sind Beugungsmessungen an Reflexen einzelner Flächen {hkl} nicht geeignet, sondern es muss die Orientierungsdichtefunktion (ODF) ermittelt werden. Deren Darstellung in Form einer inversen Polfigur zeigt die Lage und Schärfe einer eventuell vorhandenen Fasertextur. Die Orientierungsdichtefunktion muss entweder aus statistisch ausreichend vielen Einzelorientierungsmessungen konstruiert (bei EBSD) oder aus Messungen einer Mindestanzahl von Polfiguren an verschiedenen Reflexen {hkl} (bei XRD) berechnet werden. Siehe hierzu: L. Spieß et al., Moderne Röntgenbeugung, 2. Auflage, Vieweg & Teubner, 2009.

Bei den erfindungsgemäßen Ti₁₋ₓAlₓC_{y}N_{z}-Schichten wurde durch XRD-Messung eines Polfiguren-Satzes und ODF-Berechnung verifiziert, dass eine Fasertextur mit Faserachse entweder genau in <111>-Richtung oder in einer kristallographischen Richtung mit <10° Winkelabweichung von <111> vorliegt. Zur Quantifizierung dieser Textur kann das Intensitäts-Verhältnis der {111}- und {200}-Reflexe aus θ-2θ-Messungen herangezogen werden. Die Lage der Faserachse kann aus der inversen Polfigur oder der röntgenographisch gemessenen Polfigur des {111}-Reflexes ermittelt werden.

### Röntgendiffraktometrie

Röntgenbeugungsmessungen wurden an einem Diffraktometer des Typs GE Sensing & Inspection Technologies PTS3003 unter Verwendung von CuKα-Strahlung durchgeführt. Für θ-2θ-Eigenspannungs- und Polfigurmessungen wurde eine Parallelstrahloptik verwendet, die primärseitig aus einer Polykapillare und einem 2mm-Pinhole als Kollimator bestand. Sekundärseitig wurde ein Parallelplatten-Kollimator mit 0,4° Divergenz und ein Nickel K_{β}-Filter verwendet.

Peakintensitäten und -halbwertsbreiten wurden anhand von θ-2θ-Messungen bestimmt. Nach Abzug des Untergrundes wurden Pseudo-Voigt-Funktionen an die Messdaten gefittet, wobei der Kα₂-Abzug mittels Kα₁/Kα₂-Dublett-Anpassung erfolgte. Die in Tabelle 4 aufgeführten Werte der Intensitäten und Halbwertsbreiten beziehen sich auf die derart angefitteten Kα₁-Inteferenzen. Die Gitterkonstanten sind nach dem Vergardschen Gesetz unter Annahme der Gitterkonstanten von TiN und AIN aus den PDF-Karten 38-1420 bzw. 46-1200 berechnet.

### Unterscheidung zwischen kubisch flächenzentriertem (fcc) Ti₁₋ₓAlₓC_{y}N_{z} und hexagonalem AIN

Die {101}- bzw. {202}-Interferenzen von hexagonalem AIN und der {111}- bzw. {222}-Reflex von kubischem Ti₁₋ₓAlₓC_{y}N_{z} können sich je nach chemischer Zusammensetzung mehr oder weniger stark überlagern. Lediglich die Interferenz der {200}-Ebene des kubischen Ti₁₋ₓAlₓC_{y}N_{z} wird durch keine weiteren Interferenzen, wie z. B. durch den Substratkörper oder darüber oder darunter angeordnete Lagen, überlagert und besitzt für regellose Orientierung die höchste Intensität.

Zur Beurteilung des Volumenanteils an hexagonalem AIN im Messvolumen und zur Vermeidung von Fehlinterpretationen bezüglich der {111}- und {200}-Intensitäten des kubischen Ti₁₋ₓAlₓC_{y}N_{z}, wurden Messungen (θ-2θ-Scans) unter zwei verschiedenen Kippwinkeln ψ (ψ = 0° und ψ = 54,74°) durchgeführt. Da der Winkel zwischen den Ebenennormalen von {111} und {200} etwa 54,74° beträgt, ergibt sich bei einer starken {111}-Fasertextur ein Intensitätsmaximum des {200}-Reflexes bei dem Kippwinkel ψ = 54,74°, während die Intensität des {111}-Reflexes gegen Null geht. Umgekehrt erhält man bei dem Kippwinkel ψ = 54,74° ein starkes Intensitätsmaximum des {111}-Reflexes bei einer starken {200}-Fasertextur, während die Intensität des {200}-Reflexes gegen Null geht.

Für die gemäß den Beispielen hergestellten texturierten Schichten kann auf diese Weise überprüft werden, ob die gemessene Intensität bei 2θ ≈ 38,1° vornehmlich der kubisch flächenzentrierten Ti₁₋ₓAlₓC_{y}N_{z}-Phase zuzuordnen ist oder ob größere Anteile von hexagonalem AIN in der Schicht enthalten sind. Sowohl Röntgenbeugungsmessungen als auch EBSD-Messungen zeigen übereinstimmend nur sehr geringe Anteile hexagonaler AIN-Phase in den erfindungsgemäßen Schichten.

### Polfiguren

Polfiguren des {111}-Reflexes wurden bei 2θ = 38,0° über einen Winkelbereich von 0°<α<75° (Inkrement 5°) und 0°<β<360° (Inkrement 5°) bei kreisförmiger Anordnung der Messpunkte erstellt. Die Intensitätsverteilung aller gemessenen und rückgerechneten Polfiguren war annähernd rotationssymmetrisch, d.h. die untersuchten Schichten wiesen Fasertexturen auf. Zur Überprüfung der Vorzugsorientierung wurden zusätzlich zur {111}-Polfigur an den {200}- und {220}-Reflexen Polfiguren gemessen. Die Orientierungsdichte-Verteilungsfunktion (ODF) wurde mit der Software LaboTex3.0 der Firma LaboSoft, Polen, berechnet und die Vorzugsorientierung als inverse Polfigur dargestellt. Bei den erfindungsgemäßen Schichten befand sich das Intensitätsmaximum in <111>-Richtung oder ≤ 10° Winkelabweichung von <111>.

### Eigenspannungsanalysen

Für die Eigenspannungsanalysen nach der sin²ψ-Methode wurde die {222}-Interferenz der kubisch flächenzentrierten Ti₁₋ₓAlₓC_{y}N_{z}-Lage verwendet und unter 25 ψ-Winkeln von -60° bis 60° (Inkrement 5°) vermessen. Nach Untergrundabzug, Lorentz-Polarisation-Korrektur und Kα₂-Abzug (Rachinger-Trennung) wurden die Linienlagen der Interferenzen mittels Anpassung von Profilfunktionen an die Messdaten bestimmt. Die verwendeten elastischen Kostanten waren ½s₂ = 1,93 TPa⁻¹ und s₁ = -0,18 TPa⁻¹. Die Eigenspannung in der WC-Phase des Hartmetall-Substrats wurde in gleicher Weise anhand der {201}-Interferenz unter Verwendung der elastischen Konstanten ½s₂ = 1,66 TPa⁻¹ und s₁ = -0,27 TPa⁻¹ bestimmt.

Eigenspannungen werden üblicherweise in der Einheit Megapascal (MPa) angegeben, wobei Zugeigenspannungen mit einem positiven Vorzeichen (+) und Druckeigenspannungen mit einem negativen Vorzeichen (-) bezeichnet werden.

### EDX-Messungen (Energiedispersive Röngenspektroskopie)

EDX-Messungen wurden an einem Rasterelektronenmikroskop Supra 40 VP der Firma Carl Zeiss bei 15 kV Beschleunigungsspannung mit einem EDX-Spektrometer Typ INCA x-act der Firma Oxford Instruments, UK, durchgeführt.

### Mikrohärte-Bestimmung

Die Messung der Mikrohärte erfolgte nach DIN EN ISO 14577-1 und -4 mit einem Universalhärteprüfer Fischerscope H100 der Firma Helmut Fischer GmbH, Sindelfingen, Deutschland, an einem Querschliff der beschichteten Körper.

### Strahlbehandlung

Die in den Beispielen beschichteten Hartmetall-Wendeschneidplatten wurden nach der CVD-Beschichtung einer Druckluft-Trockenstrahlbehandlung unterzogen. Die Eigenspannungen in der Ti₁₋ₓAlₓC_{y}N_{z}-Schicht und im Substrat (WC) wurden vor und nach der Strahlbehandlung gemessen. Die verwendeten Strahlparameter und die gemessenen Eigenspannungswerte sind in Tabelle 5 angegeben.

**Tabelle 3: Abscheidebedingungen Ti₁₋ₓAlₓC_{y}N_{z}-Lage**

| **Beschichtung Nr.** | **Anbindungslage** | **Abscheidebedingungen Ti₁₋ₓAlₓC_{y}N_{z}-Lage** | | | | | | | | | | | | |
|---|---|---|---|---|---|---|---|---|---|---|---|---|---|---|
| | | **Temp. [°C]** | **Druck [kPa]** | **Zeit [min]** | **Vorläufergasgemisch VG1 [Vol.-%]** | | | | | **Vorläufergasgemisch VG2 [Vol.-%]** | | | **Verhältnis Volumengasströme** *v̇* **(VG1)** / *v̇* **(VG2)** | **Dicke Ti₁₋ₓAlₓC_{y}N_{z} [µm]** |
| | | | | | H2 | N₂ | TiCl₄ | AlCl₃ | CH₃CN | H2 | N2 | NH₃ | | |
| 1 (Erf.) | TiN | 700 | 1 | 260 | 40,88 | --- | 0,08 | 0,32 | 0 | 36,56 | 21,2 | 0,96 | 0,7 | 12 |
| 2 (Erf.) | TiN | 700 | 1 | 260 | 54,35 | --- | 0,03 | 0,25 | 0 | 45,00 | --- | 0,37 | 1,2 | 6 |
| 3 (Erf.) | TiN | 700 | 1 | 260 | 53,33 | --- | 0,06 | 0,25 | 0 | 27,95 | 16,2 | 2,21 | 1,2 | 11 |
| 4 (Erf.) | TiN | 700 | 1,2 | 360 | 52,69 | --- | 0,02 | 0,16 | 0 | 46,90 | --- | 0,23 | 1,1 | 11 |
| 5 (Erf.) | TiN | 700 | 1,2 | 180 | 52,69 | --- | 0,02 | 0,16 | 0 | 46,90 | --- | 0,23 | 1,1 | 4,5 |
| 6 (Erf.) | TiN | 670 | 1,2 | 300 | 52,69 | --- | 0,02 | 0,16 | 0 | 46,90 | --- | 0,23 | 1,1 | 5 |
| 7 (Erf.) | TiCN | 720 | 1,2 | 150 | 52,69 | --- | 0,02 | 0,16 | 0,1 | 46,79 | --- | 0,23 | 1,1 | 4 |
| 8 (Vgl.) | TiN | 700 | 1 | 260 | 68,45 | --- | 0,08 | 0,31 | 0 | 28,33 | --- | 2,83 | 2,2 | 12 |

**Tabelle 4: Röntgenbeugungsdaten und Elementarzusammensetzungen der Ti₁₋ₓAlₓC_{y}N_{z}-Lagen**

| **Beschichtung Nr.** | Röntgenbeugungsintensitäten* | | | Halbwertsbreite des 111-Reflexes [°]* | Gitterkonstante a* | Elementarzusammensetzung gemäß EDX-Analyse [Atom-%]* | | | | | x in Ti₁₋ₓAlₓC_{y}N_{z}* gemäß EDX-Analyse | MikroHärte [HV_{0,005}] |
|---|---|---|---|---|---|---|---|---|---|---|---|---|
| | I(111) | I(200) | I(111)/ I(200) | | | Ti | Al | N | C | Cl | | |
| 1 (Erf.) | 2628 | 32 | 184 | 0,556 | 4,101±0,007 | 12,3 | 31,9 | 55,1 | 0 | 0,7 | 0,72±0,1 | 2750 |
| 2 (Erf.) | 1389 | 114 | 67 | 0,409 | 4,094±0,014 | 10,5 | 35,1 | 54,2 | 0 | 0,2 | 0,77±0,1 | n.g.** |
| 3 (Erf.) | 1738 | 21 | 136 | 0,414 | 4,080±0,001 | n.g. | n.g. | n.g. | n.g. | n.g. | --- | n.g.** |
| 4 (Erf.) | 5502 | 98 | 182 | 0,444 | 4,097±0,011 | 10,6 | 34,6 | 54,6 | 0 | 0,2 | 0,77±0,06 | 2939 |
| 5 (Erf.) | 2253 | 135 | 17 | 0,406 | 4,090±0,009 | n.g. | n.g. | n.g. | n.g. | n.g. | --- | n.g.** |
| 6 (Erf.) | 2635 | 85 | 38 | 0,411 | 4,084±0,004 | 6,3 | 41 | 52,5 | 0 | 0,3 | 0,87±0,01 | n.g.** |
| 7 (Erf.) | 3898 | 92 | 42 | 0,451 | 4,095±0,009 | 8,8 | 37,1 | 51,7 | 2,3 | 0,1 | 0,81±0,1 | 3040 |
| 8 (Vgl.) | 120 | 2297 | 0,06 | 3,25 | 4,129±0,004 | 16,8 | 26,1 | 55,5 | 0 | 1,6 | 0,61±0,03 | 1800 |

| | | | | | | | | | | | | |
|---|---|---|---|---|---|---|---|---|---|---|---|---|
| * Durchschnitt aus Messungen an 4 Proben von unterschiedlichen Reaktor-Positionen ** n.g. = nicht gemessen | | | | | | | | | | | | |

**Tabelle 5: Strahlbehandlung und Eigenspannungsmessungen verschiedener Beschichtungen**

| **Probe** | **Beschichtung Nr.** | **Strahlmittel** | **Strahlabstand [mm]** | **Strahldruck [bar]** | **Strahldauer [s]** | **Eigenspannung vor dem Strahlen [MPa]** | | **Eigenspannung nach dem Strahlen [MPa]** | |
|---|---|---|---|---|---|---|---|---|---|
| | | | | | | **WC** | **Ti₁₋ₓAlₓC_{y}N_{z}** | **WC** | **Ti₁₋ₓAlₓC_{y}N_{z}** |
| S1 | 2 | Edelkorund (280-320 Mesh) | 90 | 3 | 6 | -1032 | +1286 | -997 | -41 |
| S2 | 4 | Edelkorund (280-320 Mesh) | 90 | 3 | 6 | -766 | +884 | -706 | +167 |
| S3 | 2 | Edelkorund (280-320 Mesh) | 90 | 3 | 30 | -1079 | +1286 | -156 | -532 |
| S4 | 4 | Edelkorund (280-320 Mesh) | 90 | 3 | 30 | -832 | +793 | -104 | -418 |
| S5 | 5 | Edelkorund (Korngröße 106-150 µm) | 90 | 1,5 | 10 | -113 | +682 | -3627 | -3371 |
| S6 | 5 | Edelkorund (Korngröße 106-150 µm) | 90 | 2 | 30 | -113 | +682 | -4062 | -4378 |
| S7 | 4 | SiC (Korngröße 45-75 µm ) | 90 | 1,5 | 24 | -766 | +833 | -1876 | -1392 |
| S8 | 5 | ZrO₂ (Korngröße 80-125 µm) | 90 | 4 | 20 | -156 | +598 | -1096 | -832 |
| S9 | 5 | ZrO₂ (Korngröße 80-125 µm) | 90 | 6,5 | 20 | -209 | +743 | -883 | -498 |

### Zerspanversuche - Drehen

Hartmetall-Wendeschneidplatten der Geometrie CNMA120412 mit einer Zusammensetzung von 86,5 Gew.-% WC, 5,5 Gew.-% Co, 2 Gew.-% TiC, 6 Gew.-% (NbC+TaC) und mit einer mischcarbidfreien Randzone wurden mit den in Tabelle 3 angegebenen CVD-Beschichtungen Nr. 1 und Nr. 8 sowie mit der oben beschriebenen Beschichtung Nr. 9 (TiN / MT-Ti(C,N) / TiN) beschichtet. Die Gesamtschichtdicke betrug bei allen Werkzeugen etwa 12 µm. Mit den Schneideinsätzen wurden Längsdrehbearbeitungen unter folgenden Schnittbedingungen durchgeführt:

| | |
|---|---|
| Werkstückmaterial: | Grauguss GG25 |
| Kühlflüssigkeit: | Emulsion |
| Vorschub: | f = 0,32 mm |
| Schnitttiefe: | aₚ = 2,5 mm |
| Schnittgeschwindigkeit: | v_{c} = 200 m/min |

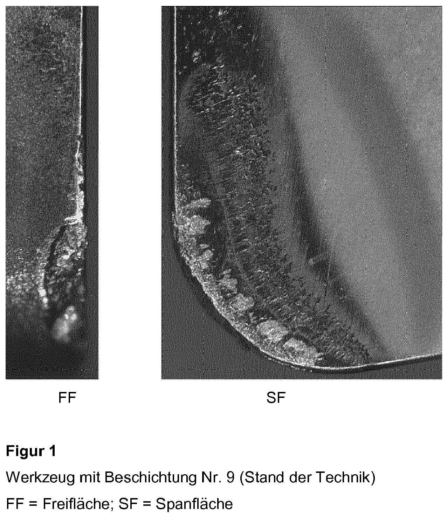

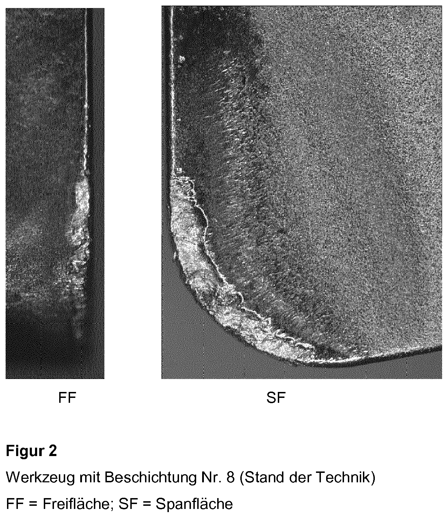

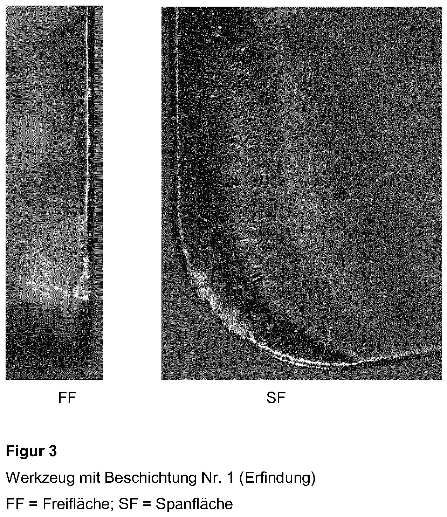

Die Figuren 1 bis 3 zeigen die eingesetzten Schneidkanten der Wendeschneidplatten nach einer Eingriffszeit von t = 9 min. Die beiden Wendeschneitplatten nach dem Stand der Technik (Figur 1: Beschichtung 9; Figur 2: Beschichtung 8) zeigen großflächige Abplatzungen der Schicht entlang der Schneidkante. Bei der Wendeschneitplatte mit der erfindungsgemäßen Ti₁₋ₓAlₓC_{y}N_{z}-Beschichtung (Figur 3: Beschichtung 1) sind kaum Abplatzungen zu beobachten.

### Zerspanversuche - Fräsen (1)

Hartmetall-Wendeschneidplatten der Geometrie SEHW1204AFN mit einer Zusammensetzung von 90,47 Gew.-% WC, 8 Gew.-% Co und 1,53 Gew.-% TaC/NbC wurden mit den in Tabelle 3 angegebenen CVD-Beschichtungen Nr. 4 und Nr. 8 beschichtet. Die Gesamtschichtdicke betrug bei allen Werkzeugen etwa 11 µm. Mit den Schneideinsätzen wurden Fräsoperationen unter folgenden Schnittbedingungen durchgeführt:

| | |
|---|---|
| Werkstückmaterial: | Kugelgraphitguss GGG70 (Festigkeit 680 MPa) |

### Gleichlauf, Trockenbearbeitung

| | |
|---|---|
| Zahnvorschub: | f_{z} = 0,2 mm |
| Schnitttiefe: | aₚ = 3 mm |
| Schnittgeschwindigkeit: | v_{c} = 185 m/min |
| Einstellwinkel: | k = 45° |
| Arbeitseingriff: | aₑ = 98 mm |
| Überstand: | uₑ = 5 mm |

Anschließend wurde die maximale Verschleissmarkenbreite v_{B,max} an der Hauptschneide nach 3200 m Fräsweg bestimmt:

| **Beschichtung Nr.** | **Verschleissmarkenbreite v_{B,max} [mm]** |
|---|---|
| 4 (Erfindung) | 0,25 |
| 8 (Stand der Technik): | 0,35 |

### Zerspanversuche - Fräsen (2)

Hartmetall-Wendeschneidplatten der Geometrie SEHW1204AFN mit einer Zusammensetzung von 90,47 Gew.-% WC, 8 Gew.-% Co und 1,53 Gew.-% TaC/NbC wurden mit der in Tabelle 3 angegebenen CVD-Beschichtung Nr. 5 sowie mit der oben beschriebenen Beschichtung Nr. 10 (TiN / MT-Ti(C,N)) beschichtet. Wendeschneidplatten mit Beschichtung Nr. 5 wurden einerseits in ungestrahltem Zustand und andererseits nach einer Trockenstrahlbehandlung mit ZrO₂ als Strahlmittel gemäß Probe S8 in Tabelle 5 eingesetzt. Mit den Schneideinsätzen wurden Fräsoperationen unter folgenden Schnittbedingungen durchgeführt:

| | |
|---|---|
| Werkstückmaterial: | Grauguss GG25 |

### Gleichlauf, Trockenbearbeitung

| | |
|---|---|
| Zahnvorschub: | f_{z} = 0,2 mm |
| Schnitttiefe: | aₚ = 3 mm |
| Schnittgeschwindigkeit: | v_{c} = 283 m/min |
| Einstellwinkel: | k = 45° |
| Arbeitseingriff: | aₑ = 98 mm |
| Überstand: | uₑ = 5 mm |

Anschließend wurde die mittlere Verschleissmarkenbreite v_{B} und die Anzahl der Kammrisse an der Hauptschneide nach 2400 m Fräsweg bestimmt:

| **Beschichtung Nr.** | **Verschleissmarkenbreite v_{B} [mm]** | **Kammrisse** |
|---|---|---|
| 5 ungestrahlt (Erfindung) | 0,05 | 3 |
| 5 gestrahlt (Erfindung) | 0,05 | 0 |
| 10 (Stand der Technik): | 0,10 | 8 |

### Zerspanversuche - Fräsen (3)

Hartmetall-Wendeschneidplatten der Geometrie SEHW1204AFN mit einer Zusammensetzung von 90,47 Gew.-% WC, 8 Gew.-% Co und 1,53 Gew.-% TaC/NbC wurden mit der in Tabelle 3 angegebenen CVD-Beschichtung Nr. 5 sowie mit der oben beschriebenen Beschichtung Nr. 10 (TiN / MT-Ti(C,N)) beschichtet. Es wurden je Beschichtungsvariante 3 Schneideinsätze getestet. Mit den Schneideinsätzen wurden Fräsoperationen unter folgenden Schnittbedingungen durchgeführt:

| | |
|---|---|
| Werkstückmaterial: | Baustahl St37 (Festigkeit ca. 500 MPa) |

### Gleichlauf, Trockenbearbeitung

| | |
|---|---|
| Zahnvorschub: | f_{z} = 0,3 mm |
| Schnitttiefe: | aₚ = 6 mm |
| Schnittgeschwindigkeit: | v_{c} = 299 m/min |
| Einstellwinkel: | k = 75° |
| Arbeitseingriff: | aₑ = 50 mm |
| Überstand: | uₑ =350 mm |

Anschließend wurde die Anzahl der Kammrisse an der Hauptschneide nach 3200 m Fräsweg bestimmt:

| **Beschichtung Nr.** | **Kammrisse** |
|---|---|
| 5 (Erfindung) - 1 | 0 |
| 5 (Erfindung) - 2 | 0 |
| 5 (Erfindung) - 3 | 0 |
| 10 (Stand der Technik) - 1 | 4 |
| 10 (Stand der Technik) - 2 | 3 |
| 10 (Stand der Technik) - 3 | 3 |

## Patentansprüche

1. Verfahren zur Herstellung eines Werkzeugs mit einem Grundkörper aus Hartmetall, Cermet, Keramik, Stahl oder Schnellarbeitsstahl und einer darauf im CVD-Verfahren aufgebrachten ein- oder mehrlagigen Verschleißschutzbeschichtung, wobei die Verschleißschutzbeschichtung wenigstens eine Ti₁₋ₓAlₓC_{y}N_{z}-Lage aufweist mit Stöchiometriekoeffizienten 0,70 ≤ x < 1, 0 ≤ y < 0,25 und 0,75 ≤ z < 1,15 und mit einer Dicke im Bereich von 1 µm bis 25 µm, wobei zur Herstellung der Ti₁₋ₓAlₓC_{y}N_{z}-Lage
a) die zu beschichtenden Körper in einem im Wesentlichen zylindrischen CVD-Reaktor platziert werden, der für ein Anströmen der zu beschichtenden Körper mit den Prozessgasen in einer Richtung im Wesentlichen radial zur Längsachse des Reaktors ausgelegt ist,
b) zwei Vorläufergasgemische (VG1) und (VG2) bereitgestellt werden, wobei
das erste Vorläufergasgemisch (VG1)
0,005% bis 0,2 Vol.-% TiCl₄,
0,025% bis 0,5 Vol.-% AlCl₃ und
als Trägergas Wasserstoff (H₂) oder ein Gemisch aus Wasserstoff und Stickstoff (H₂/N₂) enthält und
das zweite Vorläufergasgemisch (VG2)
0,1 bis 3,0 Vol.-% wenigstens eines N-Donors, ausgewählt unter Ammoniak (NH₃) und Hydrazin (N₂H₄), und
als Trägergas Wasserstoff (H₂) oder ein Gemisch aus Wasserstoff und Stickstoff (H₂/N₂) enthält,
und das erste Vorläufergasgemisch (VG1) und/oder das zweite Vorläufergasgemisch (VG2) gegebenenfalls einem C-Donor, ausgewählt unter Acetonitril (CH₃CN), Ethan (C₂H₆), Ethen (C₂H₄) und Ethin (C₂H₂) und Gemischen davon, enthält, wobei der Gesamt-Vol.-%-Anteil von N-Donor und C-Donor in den Vorläufergasgemischen (VG1, VG2) im Bereich von 0,1 bis 3,0 Vol.-% liegt,
c) die zwei Vorläufergasgemische (VG1, VG2) vor dem Eintritt in die Reaktionszone getrennt gehalten werden und bei einer Prozesstemperatur im CVD-Reaktor im Bereich von 600°C bis 850 °C und einem Prozessdruck im CVD-Reaktor im Bereich von 0,2 bis 18 kPa im Wesentlichen radial zur Längsachse des Reaktors eingeleitet werden,
wobei das Verhältnis der Volumengasströme (*V̇*) der Vorläufergasgemische (VG1, VG2) *V̇* (VG1) / *V̇* (VG2) kleiner als 1,5 beträgt.

2. Verfahren nach Anspruch 1, **dadurch gekennzeichnet, dass** die Prozesstemperatur im CVD-Reaktor im Bereich von 650°C bis 800 °C, vorzugsweise im Bereich von 675°C bis 750 °C liegt und/oder der Prozessdruck im CVD-Reaktor im Bereich von 0,2 bis 7 kPa, vorzugsweise im Bereich von 0,4 bis 1,8 kPa liegt.

3. Verfahren nach einem der vorangegangenen Ansprüche, **dadurch gekennzeichnet, dass** das Verhältnis der Volumengasströme (*V̇*) der Vorläufergasgemische (VG1, VG2) *V̇* (VG1) / *V̇* (VG2) kleiner als 1,25, vorzugsweise kleiner als 1,15 beträgt.

4. Verfahren nach einem der vorangegangenen Ansprüche, **dadurch gekennzeichnet, dass** die Konzentration von TiCl₄ in dem Vorläufergasgemisch (VG1) und die Konzentration von N-Donor in dem Vorläufergasgemisch (VG2) so eingestellt werden, dass das molare Verhältnis von Ti zu N in den in Stufe c) in den Reaktor einleiteten Volumengasströmen *V̇* (VG1) und *V̇* (VG2) ≤ 0,25 beträgt.

5. Verfahren nach einem der vorangegangenen Ansprüche, **dadurch gekennzeichnet, dass** das zweite Vorläufergasgemisch (VG2) ≤ 1,0 Vol.-%, vorzugsweise ≤ 0,6 Vol.-% des N-Donors enthält.

6. Verfahren nach einem der vorangegangenen Ansprüche, **dadurch gekennzeichnet, dass** der N-Donor Ammoniak (NH₃) ist.

7. Verfahren nach einem der vorangegangenen Ansprüche, **dadurch gekennzeichnet, dass** die Verschleißschutzbeschichtung einer Strahlbehandlung mit einem partikulären Strahlmittel, vorzugsweise Korund, unter Bedingungen unterzogen wird, dass die Ti₁₋ₓAlₓC_{y}N_{z}-Lage nach der Strahlbehandlung Eigenspannungen im Bereich von +300 bis -5000 MPa, vorzugsweise im Bereich von -1 bis -3500 MPa aufweist.

8. Werkzeug mit einem Grundkörper aus Hartmetall, Cermet, Keramik, Stahl oder Schnellarbeitsstahl und einer darauf im CVD-Verfahren aufgebrachten ein- oder mehrlagigen Verschleißschutzbeschichtung, wobei die Verschleißschutzbeschichtung wenigstens eine Ti₁₋ₓAlₓC_{y}N_{z}-Lage aufweist mit Stöchiometriekoeffizienten 0,70 ≤ x < 1, 0 ≤ y < 25 und 0,75 ≤ z < 1,15, **dadurch gekennzeichnet, dass**
die Ti₁₋ₓAlₓC_{y}N_{z}-Lage eine Dicke im Bereich von 1 µm bis 25 µm hat und eine kristallographische Vorzugsorientierung aufweist, die durch ein Verhältnis der Intensitäten der Röntgenbeugungspeaks der kristallografischen {111}-Ebene und der {200}-Ebene charakterisiert ist, bei dem I{111} / I{200} > 1+h (In h)², wobei h die Dicke der Ti₁₋ₓAlₓC_{y}N_{z}-Lage in "µm" ist.

9. Werkzeug nach Anspruch 8, **dadurch gekennzeichnet, dass** die Halbwertsbreite (FWHM) des Röntgenbeugungspeaks der {111}-Ebene der Ti₁₋ₓAlₓC_{y}N_{z}-Lage < 1°, vorzugsweise < 0,6°, besonders bevorzugt < 0,45° beträgt.

10. Werkzeug nach einem der Ansprüche 8 oder 9, **dadurch gekennzeichnet, dass** die Ti₁₋ₓAlₓC_{y}N_{z}-Lage wenigstens 90 Vol.-% Ti₁₋ₓAlₓC_{y}N_{z}-Phase mit kubisch flächenzentriertem (fcc) Gitter, vorzugsweise wenigstens 95 Vol.-% Ti₁₋ₓAlₓC_{y}N_{z}-Phase mit kubisch flächenzentriertem (fcc) Gitter, besonders bevorzugt wenigstens 98 Vol.-% Ti₁₋ₓAlₓC_{y}N_{z}-Phase mit kubisch flächenzentriertem (fcc) Gitter aufweist.

11. Werkzeug nach einem der Ansprüche 8 bis 10, **dadurch gekennzeichnet, dass** die Ti₁₋ₓAlₓC_{y}N_{z}-Lage Stöchiometriekoeffizienten 0,70 ≤ x < 1, y = 0 und 0,95 ≤ z < 1,15 aufweist.

12. Werkzeug nach einem der Ansprüche 8 bis 11, **dadurch gekennzeichnet, dass** die Ti₁₋ₓAlₓC_{y}N_{z}-Lage eine Dicke im Bereich von 3 µm bis 20 µm, vorzugsweise im Bereich von 4 bis 15 µm aufweist.

13. Werkzeug nach einem der Ansprüche 8 bis 12, **dadurch gekennzeichnet, dass** das Verhältnis der Intensitäten der Röntgenbeugungspeaks der kristallografischen {111}-Ebene und der (200)-Ebene derTi₁₋ₓAlₓC_{y}N_{z}-Lage > 1+(h+3) (In h)² beträgt.

14. Werkzeug nach einem der Ansprüche 8 bis 13, **dadurch gekennzeichnet, dass** die Ti₁₋ₓAlₓC_{y}N_{z}-Lage eine Vickers-Härte (HV) > 2300 HV, vorzugsweise > 2750 HV, besonders bevorzugt > 3000 HV aufweist.

15. Werkzeug nach einem der Ansprüche 8 bis 14, **dadurch gekennzeichnet,**
**dass** zwischen dem Grundkörper und der Ti₁₋ₓAlₓC_{y}N_{z}-Lage wenigstens eine weitere Hartstofflage angeordnet ist, ausgewählt unter einer TiN-Lage, einer mittels Hochtemperatur-CVD (CVD) oder Mitteltemperatur-CVD (MT-CVD) abgeschiedenen TiCN-Lage, einer Al₂O₃-Lage und Kombinationen davon und/oder
**dass** über der Ti₁₋ₓAlₓC_{y}N_{z}-Lage wenigstens eine weitere Hartstofflage angeordnet ist, vorzugsweise wenigstens eine Al₂O₃-Lage der Modifikation γ-Al₂O₃, κ-Al₂O₃ oder α-Al₂O₃, besonders bevorzugt eine α-Al₂O₃-Lage, wobei die Al₂O₃-Lage mittels Hochtemperatur-CVD (CVD) oder Mitteltemperatur-CVD (MT-CVD) abgeschieden ist.

16. Werkzeug nach einem der Ansprüche 8 bis 15, **dadurch gekennzeichnet, dass** sich das röntgenographisch oder mittels EBSD gemessene absolute Maximum der Beugungsintensität der kristallographischen {111}-Ebenen der fcc-Ti₁₋ₓAlₓC_{y}N_{z}-Schicht innerhalb eines Winkelbereichs von α = ±10°, bevorzugt innerhalb α = ±5°, besonders bevorzugt innerhalb α = ±1° befindet, ausgehend von der Normalenrichtung der Probenoberfläche.

17. Werkzeug nach einem der Ansprüche 8 bis 16, hergestellt nach einem der Ansprüche 1 bis 16.

## Claims

1. A process for the production of a tool having a base body of cemented carbide, cermet, ceramic, steel or high speed steel and a single-layer or multi-layer wear-protection coating applied thereto in a CVD process, wherein the wear-protection coating has at least one
Ti₁₋ₓAlₓC_{y}N_{z} layer having stoichiometry coefficients 0.70 ≤ x < 1, 0 ≤ y < 0.25 and 0.75 ≤ z < 1.15 and of a thickness in the range of 1 µm to 25 µm, wherein for production of the Ti₁₋ₓAlₓC_{y}N_{z} layer
a) the bodies to be coated are placed in a substantially cylindrical CVD reactor designed for an afflux flow on the bodies to be coated with the process gases in a direction substantially radially relative to the longitudinal axis of the reactor,
b) two precursor gas mixtures (VG1) and (VG2) are provided, wherein the first precursor gas mixture (VG1) contains
0.005% to 0.2 vol-% TiCl₄,
0.025% to 0.5 vol-% AlCl₃ and
as a carrier gas hydrogen (H₂) or a mixture of hydrogen and nitrogen (H₂/N₂), and
wherein the second precursor gas mixture (VG2) contains
0.1 to 3.0 vol-% of at least one N-donor selected from ammonia (NH₃) and hydrazine (N₂H₄), and
as a carrier gas hydrogen (H₂) or a mixture of hydrogen and nitrogen (H₂/N₂),
and the first precursor gas mixture (VG1) and/or the second precursor gas mixture (VG2) optionally contains a C-donor selected from acetonitrile (CH₃CN), ethane (C₂H₆), ethene (C₂H₄) and ethyne (C₂H₂) and mixtures thereof, wherein the total vol-% proportion of N-donor and C-donor in the precursor gas mixtures (VG1, VG2) is in the range of 0.1 to 3.0 vol-%,
c) the two precursor gas mixtures (VG1, VG2) are kept separate before passing into the reaction zone and are introduced substantially radially relative to the longitudinal axis of the reactor at a process temperature in the CVD reactor in the range of 600°C to 850°C and a process pressure in the CVD reactor in the range of 0.2 to 18 kPa,
wherein the ratio of the volume gas flows (*V̇*) of the precursor gas mixtures (VG1, VG2) *V̇* (VG1) / *V̇* (VG2) is less than 1.5.

2. A process according to claim 1, **characterized in that** the process temperature in the CVD reactor is in the range of 650°C to 800°C, preferably in the range of 675°C to 750°C and/or the process pressure in the CVD reactor is in the range of 0.2 to 7 kPa, preferably in the range of 0.4 to 1.8 kPa.

3. A process according to one of the preceding claims, **characterized in that** the ratio of the volume gas flows (*V̇*) of the precursor gas mixtures (VG1, VG2) *V̇* (VG1) / *V̇* (VG2) is less than 1.25, preferably less than 1.15.

4. A process according to one of the preceding claims, **characterized in that** the concentration of TiCl₄ in the precursor gas mixture (VG1) and the concentration of N-donor in the precursor gas mixture (VG2) are so set that the molar ratio of Ti to N in the volume gas flows *V̇* (VG1) and *V̇* (VG2) introduced into the reactor in stage c) is ≤ 0.25.

5. A process according to one of the preceding claims, **characterized in that** the second precursor gas mixture (VG2) contains ≤ 1.0 vol-%, preferably ≤ 0.6 vol-%, of the N-donor.

6. A process according to one of the preceding claims, **characterized in that** the N-donor is ammonia (NH₃).

7. A process according to one of the preceding claims, **characterized in that** the wear-protection coating is subjected to a blasting treatment with a particulate blasting agent, preferably corundum, under conditions such that the Ti₁₋ₓAlₓC_{y}N_{z} layer after the blasting treatment has residual stresses in the range of +300 to -5000 MPa, preferably in the range of -1 to 3500 MPa.

8. A tool having a base body of cemented carbide, cermet, ceramic, steel or high speed steel and a single-layer or multi-layer wear-protection coating applied thereto in a CVD process, wherein the wear-protection coating includes at least one Ti₁₋ₓAlₓC_{y}N_{z} layer having stoichiometry coefficients 0.70 ≤ x < 1, 0 ≤ y < 0.25 and 0.75 ≤ z < 1.15, **characterized in that**
the Ti₁₋ₓAlₓC_{y}N_{z} layer is of a thickness of 1 µm to 25 µm and has a crystallographic preferential orientation, which is **characterised by** a ratio of the intensities of the X-ray diffraction peaks of the crystallographic {111} plane and the {200} plane, wherein
I{111}/I{200} > 1 + h (In h)², wherein h is the thickness of the Ti₁₋ₓAlₓC_{y}N_{z} layer in micrometers.

9. A tool according to claim 8, **characterized in that** the full-width half-maximum (FWHM) of the X-ray diffraction peak of the {111} plane of the Ti₁₋ₓAlₓC_{y}N_{z} layer is < 1°, preferably < 0.6°, particularly preferably < 0.45°.

10. A tool according to one of claims 8 or 9, **characterized in that** the Ti₁₋ₓAlₓC_{y}N_{z} layer has at least 90 vol-% Ti₁₋ₓAlₓC_{y}N_{z} phase with a face-centred cubic (fcc) lattice, preferably at least 95 vol-% Ti₁₋ₓAlₓC_{y}N_{z} phase with a face-centred cubic (fcc) lattice, particularly preferably at least 98 vol-% Ti₁₋ₓAlₓC_{y}N_{z} phase with a face-centred cubic (fcc) lattice.

11. A tool according to one of claims 8 to 10, **characterized in that** the Ti₁₋ₓAlₓC_{y}N_{z} layer has stoichiometry coefficients 0.70 ≤ x < 1, y = 0 and 0.95 ≤ z < 1.15.

12. A tool according to one of claims 8 to 11, **characterized in that** the Ti₁₋ₓAlₓC_{y}N_{z} layer has a thickness in the range of 3 µm to 20 µm, preferably in the range of 4 to 15 µm.

13. A tool according to one of claims 8 to 12, **characterized in that** the ratio of the intensities of the X-ray diffraction peaks of the crystallographic {111} plane and the {200} plane of the Ti₁₋ₓAlₓC_{y}N_{z} layer is > 1 + (h+3) (In h)².

14. A tool according to one of claims 8 to 13, **characterized in that** the Ti₁₋ₓAlₓC_{y}N_{z} layer has a Vickers hardness (HV) > 2300 HV, preferably > 2750 HV, particularly preferably > 3000 HV.

15. A tool according to one of claims 8 to 14, **characterized in that** between the base body and the Ti₁₋ₓAlₓC_{y}N_{z} layer, at least one further hard material layer is arranged, selected from a TiN layer, a TiCN layer deposited by means of high temperature CVD (CVD) or medium temperature CVD (MT-CVD), an Al₂O₃ layer and combinations thereof, and/or that over the Ti₁₋ₓAlₓC_{y}N_{z} layer, at least one further hard material layer is arranged, preferably at least one Al₂O₃ layer of the modification γ-Al₂O₃, κ-Al₂O₃ or α-Al₂O₃, particularly preferably a α-Al₂O₃ layer, wherein the Al₂O₃ layer is deposited by means of high temperature CVD (CVD) or medium temperature CVD (MT-CVD).

16. A tool according to one of claims 8 to 15, **characterized in that** an absolute maximum, measured radiographically or by means of EBSD, of the diffraction intensity of the crystallographic {111} planes of the fcc Ti₁₋ₓAlₓC_{y}N_{z} layer is within an angle range of α = ± 10°, preferably within α = ± 5°, particularly preferably within α = ± 1°, starting from the normal direction of the sample surface.

17. A tool according to one of claims 8 to 16, manufactured according to one of claims 1 to 16.

## Revendications

1. Procédé de fabrication d'un outil comportant un corps de base en métal dur, cermet, céramique, acier ou acier à coupe rapide, et un revêtement de protection contre l'usure, monocouche ou multicouche, appliqué dessus par le procédé CVD, le revêtement de protection contre l'usure présentant au moins une couche de Ti₁₋ₓAlₓC_{y}N_{z} présentant des coefficients stoechiométriques 0,70 ≤ x < 1, 0 ≤ y < 0,25 et 0,75 ≤ z < 1,15, une épaisseur comprise dans la plage de 1 µm à 25 µm, procédé dans lequel, pour la fabrication de la couche de Ti₁₋ₓAlₓC_{y}N_{z},
a) on place les corps à revêtir dans un réacteur CVD essentiellement cylindrique, qui est conçu pour insuffler les gaz de procédé sur le corps à revêtir dans une direction pour l'essentiel radiale par rapport à l'axe longitudinal du réacteur,
b) on fournit deux mélanges de gaz précurseurs (VG1) et (VG2),
le premier mélange de gaz précurseurs (VG1) contenant
0,005 % à 0,2 % en volume de TiCl₄, 0,025 % à 0,5 % en volume d'AlCl₃, et
en tant que gaz support de l'hydrogène (H₂) ou un mélange d'hydrogène et d'azote (H₂/N₂), et
le deuxième mélange de gaz précurseurs (VG2) contenant
0,1 à 3,0 % en volume d'au moins un donneur de N, choisi parmi l'ammoniac (NH₃) et l'hydrazine (N₂H₄), et
en tant que gaz support de l'hydrogène (H₂) ou un mélange d'hydrogène et d'azote (H₂/N₂),
et le premier mélange de gaz précurseurs (VG1) et/ou le deuxième mélange de gaz précurseurs (VG2) contenant éventuellement un donneur de C choisi parmi l'acétonitrile (CH₃CN), l'éthane (C₂H₆), l'éthène (C₂H₄) et l'éthyne (C₂H₂) et des mélanges de ceux-ci, le pourcentage total en volume du donneur de N et du donneur de C dans les mélanges de gaz précurseurs (VG1, VG2) étant compris dans la plage de 0,1 à 3,0 % en volume,
c) on maintient les deux mélanges de gaz précurseurs (VG1, VG2) séparés en amont de leur entrée dans la zone de réaction, et à une température de procédé dans le réacteur CVD comprise dans la plage de 600 °C à 850 °C et sous une pression de procédé dans le réacteur CVD comprise dans la plage de 0,2 à 18 kPa, on les introduit pour l'essentiel radialement par rapport à l'axe longitudinal du réacteur,
le rapport entre les débits volumiques de gaz (*V̇*) des mélanges de gaz précurseurs (VG1, VG2) *V̇* (VG1) / *V̇* (VG2) étant inférieur à 1,5.

2. Procédé selon la revendication 1, **caractérisé en ce que** la température de procédé dans le réacteur CVD est comprise dans la plage de 650 °C à 800 °C, de préférence dans la plage de 675 °C à 750 °C, et/ou que la pression de procédé dans le réacteur CVD est comprise dans la plage de 0,2 à 7 kPa, de préférence dans la plage de 0,4 à 1,8 kPa.

3. Procédé selon l'une des revendications précédentes, **caractérisé en ce que** le rapport entre les débits volumiques de gaz (*V̇*) des mélanges de gaz précurseurs (VGA, VG2), *V̇* (VG1) / *V̇* (VG2) est inférieur à 1,25, de préférence inférieur à 1,15.

4. Procédé selon l'une des revendications précédentes, **caractérisé en ce que** la concentration du TiCl₄ dans le mélange de gaz précurseurs (VG1) et la concentration du donneur de N dans le mélange de gaz précurseurs (VG2) sont ajustées de telle sorte que le rapport molaire de Ti à N dans les débits volumiques de gaz *V̇* (VG1) et *V̇* (VG2) introduits à l'étape c) dans le réacteur est ≤ 0,25.

5. Procédé selon l'une des revendications précédentes, **caractérisé en ce que** le deuxième mélange de gaz précurseurs (VG2) contient ≤ 1,0 % en volume, de préférence ≤ 0,6 % en volume du donneur de N.

6. Procédé selon l'une des revendications précédentes, **caractérisé en ce que** le donneur de N est l'ammoniac (NH₃).

7. Procédé selon l'une des revendications précédentes, **caractérisé en ce que** le revêtement de protection contre l'usure est soumis à un traitement par sablage à l'aide d'un agent de sablage particulier, de préférence le corindon, dans des conditions telles que la couche de Ti₁₋ₓAlₓC_{y}N_{z} présente après le traitement de sablage des contraintes internes comprises dans la plage de +300 à -5000 MPa, de préférence dans la plage de -1 à -3500 MPa.

8. Outil comportant un corps de base en métal dur, cermet, céramique, acier ou acier à coupe rapide et un revêtement de protection contre l'usure, monocouche ou multicouche, appliqué dessus par le procédé CVD, la couche de protection contre l'usure présentant au moins une couche de Ti₁₋ₓAlₓC_{y}N_{z} ayant des coefficients stoechiométriques 0,70 ≤ x < 1, 0 ≤ y < 0,25 et 0,75 ≤ z < 1,15, **caractérisé en ce que** la couche de Ti₁₋ₓAlₓC_{y}N_{z} présente une épaisseur comprise dans la plage de 1 µm à 25 µm et une orientation cristallographique préférentielle qui est **caractérisée par** un rapport entre les intensités des pics de diffraction des rayons X du plan cristallographique {111} et du plan {200}, pour lequel I{111}/I{200} > 1+h (ln h)², h étant l'épaisseur de la couche de Ti₁₋ₓAlₓC_{y}N_{z}, en « µm ».

9. Outil selon la revendication 8, **caractérisé en ce que** la largeur à mi-hauteur (LMH) du pic de diffraction des rayons X du plan {111} de la couche de Ti₁₋ₓAlₓC_{y}N_{z} est < 1°, de préférence < 0,6°, d'une manière particulièrement préférée < 0,45°.

10. Outil selon l'une des revendications 8 ou 9, **caractérisé en ce que** la couche de Ti₁₋ₓAlₓC_{y}N_{z} présente au moins 90 % en volume de phase Ti₁₋ₓAlₓC_{y}N_{z} présentant une structure cubique à faces centrées (cfc), de préférence au moins 95 % en volume de phase Ti₁₋ₓAlₓC_{y}N_{z} présentant une structure cubique à faces centrées (cfc), d'une manière particulièrement préférée au moins 98 % en volume de phase Ti₁₋ₓAlₓC_{y}N_{z} présentant une structure cubique à faces centrées (cfc).

11. Outil selon l'une des revendications 8 à 10, **caractérisé en ce que** la couche de Ti₁₋ₓAlₓC_{y}N_{z} présente les coefficients stoechiométriques 0,70 ≤ x < 1, y = 0 et 0,95 ≤ z < 1,15.

12. Outil selon l'une des revendications 8 à 11, **caractérisé en ce que** la couche de Ti₁₋ₓAlₓC_{y}N_{z} présente une épaisseur comprise dans la plage de 3 µm à 20 µm, de préférence dans la plage de 4 à 15 µm.

13. Outil selon l'une des revendications 8 à 12, **caractérisé en ce que** le rapport des intensités des pics de diffraction des rayons X du plan cristallographique {111} et du plan {200} de la couche de Ti₁₋ₓAlₓC_{y}N_{z} est > 1+(h+3)(ln h)².

14. Outil selon l'une des revendications 8 à 13, **caractérisé en ce que** la couche de Ti₁₋ₓAlₓC_{y}N_{z} présente une dureté Vickers (HV) > 2300 HV, de préférence > 2750 HV, d'une manière particulièrement préférée > 3000 HV.

15. Outil selon l'une des revendications 8 à 14, **caractérisé en ce que**, entre le corps de base et la couche de Ti₁₋ₓAlₓC_{y}N_{z}, est disposée au moins une couche d'un matériau dur, choisi parmi une couche de TiN, une couche de TiCN déposée par CVD à haute température (CVD) ou par CVD à température moyenne (MT-CVD), une couche d'Al₂O₃ et des combinaisons de celles-ci, et/ou **en ce que**, par-dessus la couche de Ti₁₋ₓAlₓC_{y}N_{z} est disposée une couche de matériau dur supplémentaire, de préférence au moins une couche d'Al₂O₃ de la variété □ -Al₂O₃, □□-Al₂O₃ ou □-Al₂O₃, d'une manière particulièrement préférée une couche d'□-Al₂O₃, la couche d'Al₂O₃ étant déposée par CVD à haute température (CVD) ou par CVD à température moyenne (MT-CVD).

16. Outil selon l'une des revendications 8 à 15, **caractérisé en ce que** le maximum absolu, mesuré par radiographie aux rayons X ou par EBSD, de l'intensité de diffraction des plans cristallographiques {111} de la couche de cfc-Ti₁₋ₓAlₓC_{y}N_{z} se trouve à l'intérieur d'une plage angulaire α = ± 10°, de préférence à l'intérieur de la plage α = ± 5°, d'une manière particulièrement préférée dans la plage α = ± 1°, en partant de la direction normale de la surface de l'échantillon.

17. Outil selon l'une des revendications 8 à 16, fabriqué selon l'une des revendications 1 à 16.
